# EUROPEAN PATENT SPECIFICATION

(11) **EP 3 745 428 B1**
(45) Date of publication and mention of the grant of the patent: **02.08.2023**
(21) Application number: 17936483.1
(22) Date of filing: 28.12.2017
(51) Int. Cl.: H10N 60/01, H01B 12/10

(54) **BLANK FOR MANUFACTURING A SUPERCONDUCTING COMPOSITE WIRE BASED ON NB3SN**
ROHLING ZUR HERSTELLUNG EINES SUPRALEITENDEN VERBUNDDRAHTES AUF DER BASIS VON NB3SN
ÉBAUCHE POUR LA FABRICATION D'UN CÂBLE COMPOSITE SUPRACONDUCTEUR À BASE DE NB3SN

(43) Date of publication of application: 02.12.2020
(73) Proprietor: Joint-Stock Company "TVEL", Moscow 115409 (RU)
(72) Inventor: ABDYUKHANOV, Ildar Mansurovich, Moscow, 129323 (RU); ALEKSEEV, Maxim Viktorovich, Moskovskaya oblast, 141006 (RU); TSAPLEVA, Anastasiia Sergeevna, Moskovskaya oblast, 141100 (RU); ALIEV, Ruslan Teimurovich, Moskovskaya oblast, 140251 (RU); ZUBOK, Evgenii Andreevich, Moscow, 111674 (RU); KRYLOVA, Maria Vladimirovna, Moscow, 123098 (RU); PANTSYRNY, Viktor Ivanovich, Moscow, 123098 (RU); SILAEV, Alexander Gennadevich, Moscow, 123098 (RU); ZERNOV, Sergei Mikhailovich, Moscow, 111398 (RU)
(74) Representative: Yalçiner Patent and Consulting Ltd.
(86) International application number: PCT/RU2017/001000
(87) International publication number: WO 2019/132698

(56) References cited:
- EP-A1- 2 099 080
- EP-B1- 3 062 359
- JP-A- H08 180 752
- JP-A- 2013 206 532
- RU-C2- 2 507 636
- US-A1- 2005 178 472
- US-A1- 2012 035 059

## Description

### FIELD OF THE INVENTION

The invention relates to electrical engineering when creating long composite wires based on superconducting compounds intended for manufacture of electrical products.

### BACKGROUND OF THE INVENTION

The most complex challenge in manufacture of superconducting wires based on Nb3Sn is the choice of design and technology for formation of superconducting materials. This compound has relatively low mechanical features, which significantly limits the ability to use traditional deformation methods and makes it difficult to manufacture such superconducting products as wire or tape, which are primarily needed for technical use. In addition, the modern development of high-energy physics devices requires the creation of superconducting materials with an ever-higher current-carrying capability in magnetic fields of more than 12 T.

It is proved that doping of niobium fiber material with titanium in an amount of 1-2 wt% leads to a significant increase in the critical current density of multifiber superconductors based on the Nb3Sn compound ["Superconducting critical temperatures, critical magnetic fields, lattice parameters, and chemical compositions of "bulk" pure and alloyed Nb3Sn produced by the bronze process" M.uenaga, et al - J. Appl. Phys. 59, 840 (1986), "Effects of titanium addition to the niobium cores of the multifilamentary Nb3Sn superconductors", T. Asano, Y. Iljima, K. Itoh, K. Tachikawa - J. Jap. Metals,v.47, No.12, pp. 1115-1122, 1983]. The use of niobium alloy fibers with 1-2 w% of titanium as a material leads to a sharp decrease in the deformability of composite bars and multiple breaks at the stage of drawing a composite bar to produce a wire of the desired cross section.

Various designs of bars are developed to produce composite Nb3Sn superconductors, which make it possible to produce long superconductors with the required current-carrying capability.

In the prior art, there is known bar for superconducting composite wire based on Nb3Sn, which is a set of bimetallic Cu/Nb rods and rods made of the Nb-47% Ti alloy, placed around a tin core located inside a copper matrix ["Advances in Nb3Sn Strand for Fusion and Particle Accelerator Applications", Jeffrey A. Parrell, Michael B. Field, Youzhu Zhang, and S.Hong, IEEE Transaction on applied superconductivity, vol. 15, No. 2, 2005]. The manufacture of such superconducting wires can be accompanied by the formation of a brittle intermetallic compound Ti2Cu, the presence of which reduces the deformability of a composite bar and can lead to its breakage. In addition, the arrangement of Nb-47% Ti alloy rods around the tin core can lead to uneven doping of the superconducting layer, which will reduce the current-carrying capability of the entire superconducting wire.

In the prior art, there is known superconducting composite wire made using the method (RU 2546136, publ. in 2015), which includes the formation of a superconductor composite bar comprising single niobium and Nb-Ti alloy fibers placed in a copper or copper alloy matrix, a tin source, a diffusion barrier and a copper coating, where the primary single-fiber composite bar is formed from a large number (more than 19) of niobium and Nb-Ti alloy rods, wherein the amount of titanium in relation to niobium in terms of all fiber is 0.5-5 wt%,and each mentioned primary single-fiber composite bar has copper alloy coating.

This method of manufacturing a superconductor does not describe the relative position of niobium and Nb-Ti alloy rods in a bar, which is of key importance. If Nb-Ti alloy rods are located on the border with the copper coating, then the heat treatment process performed during the wire manufacture will lead to the formation of a brittle intermetallic compound Ti2Cu. The presence of this compound inside a complex composite wire will prevent the formation of a uniform fine-grained superconducting layer, and may also lead to a decrease in plastic characteristics and breakage at the drawing stage. The formation of Ti2Cu will lead to a decrease in the titanium content of the superconducting layer and, as a consequence, to a decrease in its current-carrying capability.

The closest analogue to the proposed technical solution is the bar for manufacturing a superconducting wire based on Nb3Sn (EP 2717340, publ. 2014r), comprising a tin-bearing rod placed in the center of a copper-bearing matrix, around this rod there are many niobium-bearing rods in a copper-bearing shell, a copper case and a diffusion barrier, wherein the copper-bearing matrix and the copper-bearing shell comprise tin. A further example may be found in patent document JP2013206532, which discloses a precursor having a stabilization copper layer, a diffusion barrier layer arranged on the inner peripheral side of stabilization copper layer, and a superconducting matrix arranged on the inner peripheral side of diffusion barrier layer. The superconducting matrix contains tin segment wire, and niobium segment wire arranged, such that the circumference of tin segment wire is surrounded. The tin segment wire is equipped with tin core material arranged on the inner peripheral side of copper matrix.

During the manufacture of these superconducting wire bars, the process of intermediate operations, for example, hot molding, can be accompanied by the formetion of intermetallic compounds of niobium and tin at the boundary of a niobium-bearing rod with the copper-bearing shell. With further drawing of such a bar, these compounds will play the role of stress concentrators and lead to the destruction of elements and the wire as a whole. Also, the formation of non-superconducting intermetallic compounds at the boundary of niobium-bearing rods with the shell will prevent the formation of the superconducting compound Nb3Sn and reduce the current-carrying capability of the superconducting wire as a whole.

### SUMMARY OF THE INVENTION

The object of this invention is to produce a bar for the manufacture of superconducting composite wire based on Nb3Sn providing high current-carrying capability for use in various magnetic systems with fields higher than 12 T.

The technical result is the provision of high current-carrying capability in a superconducting composite wire based on Nb3Sn in magnetic fields with an induction higher than 12 T.

The technical result is achieved in the bar for manufacturing a superconducting composite wire based on Nb3Sn, consisting of a copper case, inside which there is a copper-bearing matrix, a tin-bearing rod is located in its center, around the rod there is a set of niobium-bearing rods in a copper-bearing shell, wherein the copper-bearing matrix is surrounded by a diffusion barrier, and niobium-bearing rod is a composite containing a matrix made of niobium or its alloy, reinforced with Nb-Ti alloy fibers located at a distance to the border with the copper-bearing shell of at least one average size of the Nb-Ti alloy fiber, and the distance between fibers is at least one average size of the Nb-Ti alloy fiber.

In a particular embodiment, the niobium-bearing rod is made of a niobium or niobium alloy sleeve, in the center of which there is a cylindrical stem made of niobium or its alloy, and niobium or niobium alloy fibers and Nb-Ti alloy fibers placed between the sleeve and the cylindrical stem.

In a particular embodiment, the niobium-bearing rod is made of a cylindrical niobium or niobium alloy stem with openings for Nb-Ti alloy fibers.

In a particular embodiment, the niobium-bearing rod is made of a plurality of niobium or niobium alloy fibers and Nb-Ti alloy fibers.

In a particular embodiment, the niobium-bearing rod is made of a plurality of niobium or niobium alloy fibers and Nb-Ti alloy fibers, located inside a niobium or niobium alloy case.

In a particular embodiment, copper rods (fillers) are placed between the copper-bearing shell and a plurality of niobium or niobium alloy fibers and Nb-Ti alloy fibers.

In a particular embodiment, niobium or niobium alloy fibers and Nb-Ti alloy fibers have the same size.

In a particular embodiment, the niobium-bearing rod is made of a cylindrical niobium or niobium alloy stem located in the center, around which niobium or niobium alloy fibers and Nb-Ti alloy fibers are located.

In a particular embodiment, the cross section of niobium or niobium alloy fibers and Nb-Ti alloy fibers is multi-faceted, for example, triangular, quadrangular, hexagonal.

In a particular embodiment, the cross section of niobium or niobium alloy fibers and Nb-Ti alloy fibers is circular.

Thus, the use of a niobium-bearing rod, in the design of which Nb-Ti alloy fibers are located in a niobium or niobium alloy matrix at a distance to the border with the copper-bearing shell of at least one average size of the Nb-Ti alloy fiber, and the distance between fibers is at least one average size of the Nb-Ti alloy fiber, provides uniform titanium doping of the superconducting layer during the diffusion annealing process. Due to this, the described design of niobium-bearing rod ensures high current-carrying capability of the superconducting composite Nb3Sn wire. Wherein, the presence of niobium or its alloy between Nb-Ti alloy fibers and the copper-bearing shell allows avoiding the formation of intermetallic compounds of the titanium-copper system, which provides high current-carrying capability of the superconducting composite wire

The use of the design of niobium-bearing rod consisting of a niobium or niobium alloy sleeve, in the center of which there is a cylindrical stem made of niobium or its alloy, and niobium or niobium alloy fibers and Nb-Ti alloy fibers placed between the sleeve and the cylindrical stem, as well as a niobium or niobium alloy cylindrical stem with openings for Nb-Ti alloy fibers, allows placing Nb-Ti alloy fibers at a distance to the border with the copper-bearing shell of at least one average size of these fibers and getting high current-carrying capability of superconducting composite wire.

The manufacture of niobium-bearing rod from a variety of niobium or niobium alloy fibers and Nb-Ti alloy fibers, as well as using copper rods (fillers), and niobium or niobium alloy covers, allows placing Nb-Ti alloy fibers in such a way as to obtain a minimally branched Cu/Nb boundary, and allows obtaining a high current-carrying capability of superconducting composite wire. A strongly branched Cu/Nb boundary may cause non-uniform doping of the superconducting layer with titanium, which leads to the appearance of areas with different current-carrying capability inside the superconductor. This, in turn, may lead to a decrease in the critical current of the entire superconductor.

### BRIEF DESCRIPTION OF THE DRAWINGS

The proposed invention is explained by drawings.

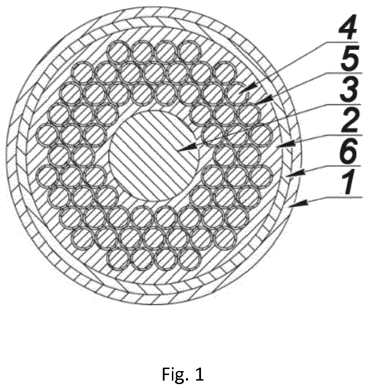

Figure 1 shows the bar cross-section. Each bar comprises a copper case 1 inside which there is a copper-bearing matrix 2, in the center of which a tin-bearing rod 3 is placed, around which there is a multitude of niobium-bearing rods 4 in a copper-bearing shell 5, wherein the copper-bearing matrix is surrounded by a diffusion barrier 6.

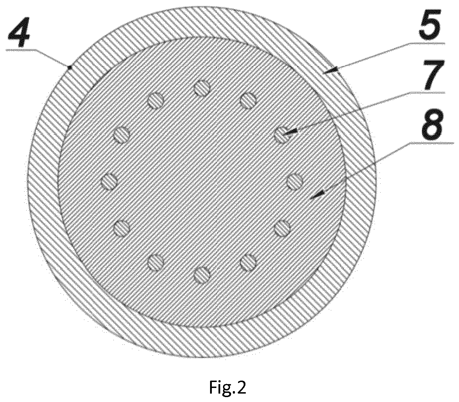

Figure 2 shows a cross section of the niobium-bearing rod 4 in the copper-bearing shell 5. Niobium-bearing rod 4 is a composite, where the niobium or niobium alloy matrix 7 is reinforced with Nb-Ti alloy fibers 8, which are located at a distance to the border with the copper-bearing shell 5 of at least one average fiber size, and the distance between them is at least one average fiber size.

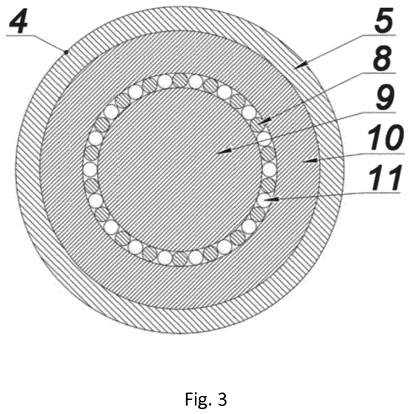

Figure 3-8 shows different embodiments of the niobium-bearing rod 4 in the copper-bearing shell 5.

In a particular embodiment (fig. 3), the niobium-bearing rod 4 is made of a cylindrical niobium or niobium alloy stem 9 located in the center of a niobium or niobium alloy sleeve 10, niobium or niobium alloy fibers 11 and Nb-Ti alloy fibers 8 located between the sleeve 10 and cylindrical stem 9.

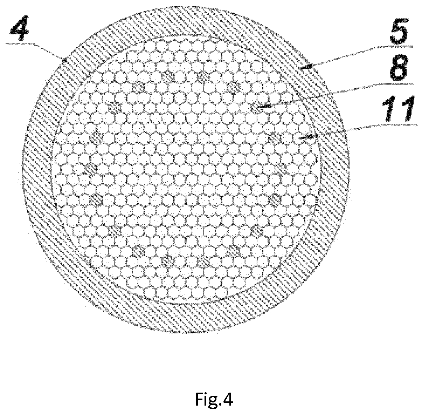

In a particular embodiment (fig. 4), the niobium-bearing rod 4 is made of a plurality of niobium or niobium alloy fibers 11 and Nb-Ti alloy fibers 8.

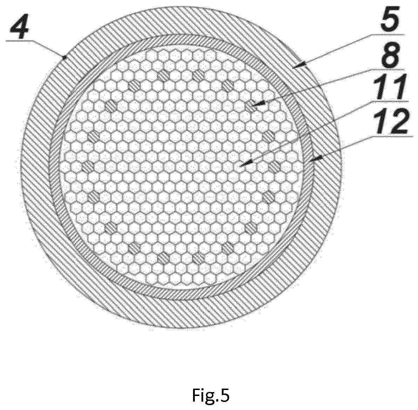

In a particular embodiment (fig. 5), the niobium-bearing rod 4 is made of a plurality of niobium or niobium alloy fibers 11 and Nb-Ti alloy fibers 8, located inside a niobium or niobium alloy case 12.

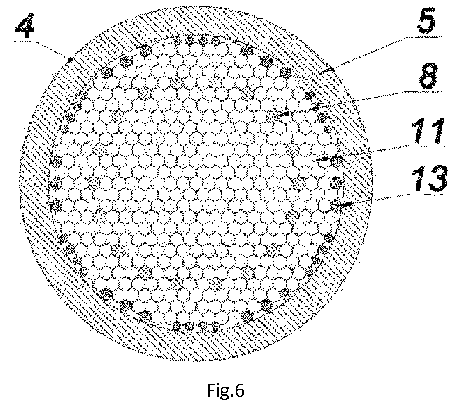

In a particular embodiment (fig. 6), copper rods (fillers) 13 are placed between the copper-bearing shell 5 and a plurality of niobium or niobium alloy fibers 11 and Nb-Ti alloy fibers 8.

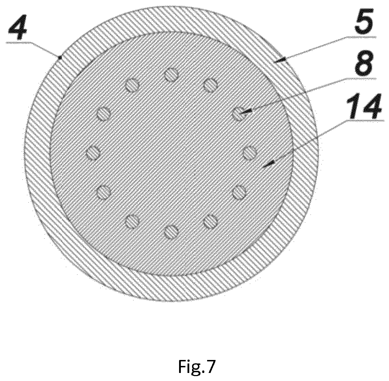

In a particular embodiment (fig. 7), the niobium-bearing rod 4 is made of a cylindrical niobium or niobium alloy stem 14 with openings for Nb-Ti alloy fibers 8.

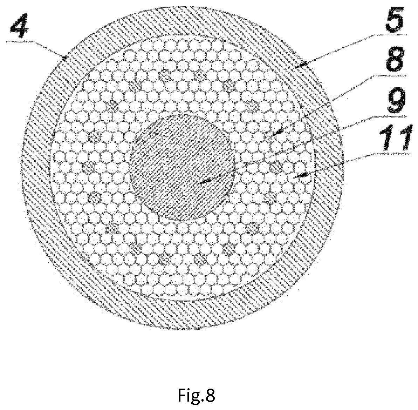

In a particular embodiment (fig. 8), the niobium-bearing rod 4 is made of a cylindrical niobium or niobium alloy cylindrical stem 9, around which niobium or niobium alloy fibers 11 and Nb-Ti alloy fibers 8 are located.

The technology for producing the claimed bar for manufacturing a superconducting composite wire based on Nb3Sn consists in placing a copper-bearing matrix inside a copper case, wherein in the center of the matrix there is a tin-bearing rod, around which many niobium-bearing rods are placed in a copper-bearing shell. Wherein, the copper-bearing matrix is placed in a diffusion barrier.

### DETAILED DESCRIPTION

### Example.

To produce a niobium-bearing rod in a copper-bearing shell, NT47 alloy rods with hexagonal cross section and the "turnkey" size of 2.7 mm in the amount of 24 pcs. was placed in a niobium matrix, consisting of niobium rods of NbM brand with hexagonal cross section and the "turnkey" size of 2.7 mm in the amount of 889 pcs., wherein each NT47 alloy rod was located at a distance to the border with a Ø100.5×89 mm copper shell of 3 average rod sizes, and the distance between adjacent NT47 rods was 2-3 average rod sizes.

The resulting bar was extruded using the PA-653 hydraulic pipe press from a container with working sleeve diameter of 100 mm into a rod with diameter of 34 mm. The extruded rod was deformed to a hexagon with "turnkey" size of 2.48 mm. The resulting hexagonal rods were cut into measured parts. Then the bar was formed as follows. The resulting measured parts of hexagonal rods were placed in a copper matrix, in the center of which a tin rod was placed. The copper matrix with measured parts of hexagonal rods placed in it was enclosed in a niobium diffusion barrier and a copper case. The bar was drawn to a "turnkey" size of 3.8 mm.

### INDUSTRIAL APPLICABILITY

On a wire produced using the set of bars, a critical current density of 2468 A/mm2 was obtained in a magnetic field with 12 T induction at a temperature of 4.2 K.

Thus, the use of the claimed bar allows producing a superconducting composite wire with a high current-carrying capability.

## Claims

1. A bar for manufacturing a superconducting composite wire based on Nb3Sn, consisting of a copper case (1), ease, inside which there is a copper-bearing matrix (2), a tin-bearing rod (3) is located in its center, around the rod there is a set of niobium-bearing rods (4) in a copper-bearing shell (5), wherein the copper-bearing matrix is surrounded by a diffusion barrier (6), wherein each niobium-bearing rod is a composite containing a matrix (7) made of niobium or its alloy, reinforced with Nb-Ti alloy fibers (8) located at a distance to the border with the copper-bearing shell of at least one average size of the Nb-Ti alloy fiber, and the distance between fibers is at least one average size of the Nb-Ti alloy fiber.

2. The bar for manufacturing a superconducting composite wire based on Nb3Sn according to claim 1, wherein the niobium-bearing rod is made of a niobium or niobium alloy sleeve, in the center of which there is a cylindrical stem made of niobium or its alloy, and niobium or niobium alloy fibers and Nb-Ti alloy fibers placed between the sleeve and the cylindrical stem.

3. The bar for manufacturing a superconducting composite wire based on Nb3Sn according to claim 1, wherein the niobium-bearing rod is made of a cylindrical niobium or niobium alloy stem with openings for Nb-Ti alloy fibers.

4. The bar for manufacturing a superconducting composite wire based on Nb3Sn according to claim 1, wherein the niobium-bearing rod is made of a plurality of niobium or niobium alloy fibers and Nb-Ti alloy fibers.

5. The bar for manufacturing a superconducting composite wire based on Nb3Sn according to claim 1, wherein the niobium-bearing rod is made of a plurality of niobium or niobium alloy fibers and Nb-Ti alloy fibers, located inside a niobium or niobium alloy case.

6. The bar for manufacturing a superconducting composite wire based on Nb3Sn according to claim 1, wherein copper rods are placed between the copper-bearing shell and a plurality of niobium or niobium alloy fibers and Nb-Ti alloy fibers.

7. The bar for manufacturing a superconducting composite wire based on Nb3Sn according to claim 1, wherein the niobium-bearing rod is made of a cylindrical niobium or niobium alloy stem located in the center, around which niobium or niobium alloy fibers and Nb-Ti alloy fibers are located.

8. The bar for manufacturing a superconducting composite wire based on Nb3Sn according to any of claims 2,4,5,6,7 wherein niobium or niobium alloy fibers and Nb-Ti alloy fibers have the same size.

9. The bar for manufacturing a superconducting composite wire based on Nb3Sn according to any of claims 2,3,4,5,6,7 wherein the cross section of niobium or niobium alloy fibers and Nb-Ti alloy fibers is multi-faceted, for example, triangular, quadrangular, hexagonal.

10. The bar for manufacturing a superconducting composite wire based on Nb3Sn according to any of claims 2,3,4,5,6,7 wherein the cross section of niobium or niobium alloy fibers and Nb-Ti alloy fibers is circular.

## Patentansprüche

1. Ein Knüppel zur Herstellung eines supraleitenden Verbunddrahtes auf Nb3 Sn-Basis, bestehend aus einer Kupferabdeckung (1), in deren Inneren sich eine kupferhaltige Matrix (2) befindet, in deren Zentrum sich ein zinnhaltiger Stab (3) befindet, um den herum sich eine Vielzahl von niobhaltigen Stäben (4) in einem kupferhaltigen Hülle (5) befindet, wobei die kupferhaltige Matrix von einer Diffusionsbarriere (6) umgeben ist, wobei jeder niobhaltige Stab ein Verbundmaterial ist, das eine Matrix (7) aus Niob oder einer Nioblegierung enthält, die durch Fasern (8) aus einer Nb-Ti-Legierung verstärkt ist, die einen Abstand von mindestens einer durchschnittlichen Größe der Faser aus der Nb-Ti-Legierung zur Grenze mit der kupferhaltigen Hülle haben, und der Abstand zwischen den Fasern mindestens eine durchschnittliche Größe der Faser aus der Nb-Ti-Legierung beträgt.

2. Der Knüppel zur Herstellung des supraleitenden Verbunddrahtes auf Nb3Sn-Basis nach Anspruch 1, wobei der niobhaltige Stab aus einer Hülse aus Niob oder einer Nioblegierung, in deren Zentrum sich ein zylindrischer Stab aus Niob oder einer Nioblegierung befindet, und Fasern aus Niob oder einer Nioblegierung und Fasern aus einer Nb-Ti-Legierung besteht, die zwischen der Hülse und dem zylindrischen Stab angeordnet sind.

3. Der Knüppel zur Herstellung des supraleitenden Verbunddrahtes auf Nb3Sn-Basis nach Anspruch 1, wobei der niobhaltige Stab aus einem zylindrischen Stab aus Niob oder einer Nioblegierung mit Löchern für Fasern aus einer Nb-Ti-Legierung besteht.

4. Der Knüppel zur Herstellung des supraleitenden Verbunddrahtes auf Nb3Sn-Basis nach Anspruch 1, wobei der niobhaltige Stab aus einer Vielzahl von Fasern aus Niob oder einer Nioblegierung und Fasern aus einer Nb-Ti-Legierung besteht.

5. Der Knüppel zur Herstellung des supraleitenden Verbunddrahtes auf Nb3Sn-Basis nach Anspruch 1, wobei der niobhaltige Stab aus einer Vielzahl von Fasern aus Niob oder einer Nioblegierung und Fasern aus einer Nb-Ti-Legierung besteht, die sich innerhalb einer Hülle aus Niob oder einer Nioblegierung befinden.

6. Der Knüppel zur Herstellung des supraleitenden Verbunddrahtes auf Nb3Sn-Basis nach Anspruch 1, wobei zwischen der kupferhaltigen Hülle und einer Vielzahl von Fasern aus Niob oder einer Nioblegierung und Fasern aus einer Nb-Ti-Legierung Kupferstäbe als Füllstoffe angeordnet sind.

7. Der Knüppel zur Herstellung des supraleitenden Verbunddrahtes auf Nb3Sn-Basis nach Anspruch 1, wobei der niobhaltige Stab aus einem im Zentrum angeordneten zylindrischen Stab aus Niob oder einer Nioblegierung besteht, um den herum Fasern aus Niob oder einer Nioblegierung und Fasern aus einer Nb-Ti-Legierung angebracht sind.

8. Der Knüppel zur Herstellung des supraleitenden Verbunddrahtes auf Nb3Sn-Basis nach einem der Ansprüche 2, 4, 5, 6, 7, wobei die Fasern aus Niob oder einer Nioblegierung und die Fasern aus einer Nb-Ti-Legierung die gleiche Größe aufweisen.

9. Der Knüppel zur Herstellung des supraleitenden Verbunddrahtes auf Nb3Sn-Basis nach einem der Ansprüche 2, 3, 4, 5, 6, 7, wobei die Fasern aus Niob oder einer Nioblegierung und Fasern aus einer Nb-Ti-Legierung einen polyedrischen, beispielsweise dreieckigen, viereckigen, sechseckigen Querschnitt aufweisen.

10. Der Knüppel zur Herstellung des supraleitenden Verbunddrahtes auf Nb3Sn-Basis nach einem der Ansprüche 2, 3, 4, 5, 6, 7, wobei Fasern aus Niob oder einer Nioblegierung und Fasern aus einer Nb-Ti-Legierung einen kreisförmigen Querschnitt aufweisen.

## Revendications

1. Un demiproduit pour la fabrication d'un fil supraconducteur compositionnel sur base de Nb3Sn qui se compose d'un coffret en cuivre (1) à l'intérieur duquel une matrice cuprifère (2) est placée au centre de laquelle une barre stannifère (3) est placée et entourée de plusieurs barres niobifères (4) dans un revêtement cuprifère (5), en cela la matrice cuprifère est entourée d'une barrière à diffusion (6), chaque barre niobifère représentant un matériau composite qui contient une matrice (7) en niobium ou en alliage de ce dernier armée de fibres (8) de l'alliage Nb-Ti placées à distance égale, au moins, à une fibre de taille moyenne de l'alliage Nb-Ti avant la ligne frontière du revêtement cuprifère et la distance entre lesquelles est égale, au moins, à une fibre de taille moyenne de l'alliage Nb-Ti.

2. Demiproduit pour la fabrication d'un fil supraconducteur compositionnel sur base de Nb3Sn selon la revendication 1, **se caractérisant en ce que** la barre niobifère est réalisée d'une douille en niobium ou en alliage de ce dernier au centre de laquelle un tige cylindrique en niobium ou en alliage de ce dernier est placé et des fibres en niobium ou en alliage de ce dernier et des fibres de l'alliage Nb-Ti placées entre la douille et le tige cylindrique.

3. Demiproduit pour la fabrication d'un fil supraconducteur compositionnel sur base de Nb3Sn selon la revendication 1, **se caractérisant en ce que** la barre niobifère est réalisée d'un tige cylindrique en niobium ou en alliage de ce dernier avec les ouvertures pour les fibres de l'alliage Nb-Ti.

4. Demiproduit pour la fabrication d'un fil supraconducteur compositionnel sur base de Nb3Sn selon la revendication 1, **se caractérisant en ce que** la barre niobifère est réalisée de plusieurs fibres en niobium ou en alliage de ce dernier et des fibres de l'alliage Nb-Ti.

5. Demiproduit pour la fabrication d'un fil supraconducteur compositionnel sur base de Nb3Sn selon la revendication 1, **se caractérisant en ce que** la barre niobifère est réalisée de plusieurs fibres en niobium ou en alliage de ce dernier et des fibres de l'alliage Nb-Ti placées à l'intérieur d'un coffret en niobium ou en alliage de ce dernier.

6. Demiproduit pour la fabrication d'un fil supraconducteur compositionnel sur base de Nb3 Sn selon la revendication 1, **se caractérisant en ce qu'**entre le revêtement cuprifère et plusieurs fibres en niobium ou en alliage de ce dernier et fibres de l'alliage Nb-Ti les barres en cuivre - matières de remplissage - sont placées.

7. Demiproduit pour la fabrication d'un fil supraconducteur compositionnel sur base de Nb3Sn selon la revendication 1, **se caractérisant en ce que** la barre niobifère est réalisée d'un tige cylindrique central en niobium ou en alliage de ce dernier placé au centre et entouré de fibres en niobium ou en alliage de ce dernier et de fibres de l'alliage Nb-Ti.

8. Demiproduit pour la fabrication d'un fil supraconducteur compositionnel sur base de Nb3Sn selon l'une quelconque des revendications 2, 4, 5, 6, 7, **se caractérisant en ce que** les fibres en niobium ou en alliage de ce dernier et les fibres de l'alliage Nb-Ti sont isométriques.

9. Demiproduit pour la fabrication d'un fil supraconducteur compositionnel sur base de Nb3Sn selon l'une quelconque des revendications 2, 3, 4, 5, 6, 7, **se caractérisant en ce que** les fibres en niobium ou en alliage de ce dernier et les fibres de l'alliage Nb-Ti ont la section multifacette, par exemple celle trigonale, tétragonale, hexagonale, transversale.

10. Demiproduit pour la fabrication d'un fil supraconducteur compositionnel sur base de Nb3Sn selon l'une quelconque des revendications 2, 3, 4, 5, 6, 7, **se caractérisant en ce que** les fibres en niobium ou en alliage de ce dernier et les fibres de l'alliage Nb-Ti ont la section transversale circulaire.
